# EUROPEAN PATENT APPLICATION

(11) **EP 3 252 532 A1**
(43) Date of publication of application: **06.12.2017**
(21) Application number: 15880072.2
(22) Date of filing: 29.10.2015
(51) Int. Cl.: G03F 1/64, B65D 85/86, H01L 21/027

(54) **SUPPORT FRAME FOR PELLICLES**

(30) Priority: 29.01.2015 JP 2015015563
(71) Applicant: Nippon Light Metal Company, Ltd., Tokyo 140-8628 (JP)
(72) Inventor: ISHITO Nobuyuki, Shizuoka-shi Shizuoka 421-3297 (JP)
(74) Representative: chapman + co
(86) International application number: PCT/JP2015/080517
(87) International publication number: WO 2016/121180

(57) **Abstract**

A pellicle support frame (1) includes a frame body (10) made of aluminum alloy. The frame body (10) has a top surface (10a) onto which a pellicle film (2) is bonded and also has an underside surface (10b) onto which a transparent substrate (M) is bonded. The frame body (10) has a height not less than 1 mm and not more than 6 mm in a top-underside direction. Grooves (20, 30) are formed on the top surface (10a) and the underside surface (10b) of the frame body (10a). The grooves (20, 30) each have a depth not less than 0.2 mm. The structure described above makes it possible to machine the support frame (1) more easily and also to prevent deformation of the transparent substrate (M) when the support frame (1) is bonded to the transparent substrate (M).

## Description

### TECHNICAL FIELD

The present invention relates to a support frame for pellicles.

### BACKGROUND ART

A process of manufacturing an integrated circuit includes a step of photolithography in which a circuit pattern drawn on a transparent substrate called a photomask or a reticle is transferred onto resist applied to a wafer.

In the photolithography step, if there is a foreign substance such as dust on the transparent substrate, the circuit pattern is not clearly transferred onto the resist. A dust-proof cover called a pellicle is thus put on the transparent substrate.

The pellicle includes: a support frame that surrounds the whole circuit pattern drawn on the transparent substrate; and a pellicle film that is transparent and is provided so as to cover an upper surface of the support frame. A lower surface of the support frame is bonded to the transparent substrate.

In some cases, the support frame described above may be, when existing alone, deformed in a top-underside direction. When bonded to the flat transparent substrate, however, the support frame is pressed against the transparent substrate, which makes the support frame flat. Nonetheless, a restoring force is generated in the support frame to restore the support frame itself to its former deformed shape. If the restoring force is large, even the transparent substrate may also be deformed together with the deformed support frame.

The deformed transparent substrate has a problem that, when a circuit pattern on the transparent substrate is transferred to resist on a wafer, the circuit pattern is formed off from a regular position.

To solve the problem described above, a technique in the related art has been disclosed in which when the support frame is bonded to the transparent substrate, a restoring force generated in the support frame can be decreased, by forming a groove on an outer and an inner circumferential surfaces of the support frame (for example, see Japanese Laid-Open Patent Application, Publication No. 2011-007934 (which may also be referred to as Patent Document 1 hereinafter).

### RELATED ART DOCUMENT

### PATENT DOCUMENT

Patent Document 1: Japanese Laid-Open Patent Application, Publication No. 2011-007934

### SUMMARY OF THE INVENTION

### PROBLEMS TO BE SOLVED BY THE INVENTION

If an outer and an inner circumferential surfaces of a support frame are significantly cut as in the support frame in the related art described above, there is a problem that machining of the support frame is complicated.

The present invention has been made in an attempt to solve the problems described above and to provide a pellicle support frame which can be manufactured with easy machining and can prevent deformation of the transparent substrate when bonded thereto.

### MEANS FOR SOLVING THE PROBLEMS

A pellicle support frame of the present invention includes a frame body made of aluminum alloy. The frame body has a top surface onto which a pellicle film is bonded and has an underside surface onto which a transparent substrate is bonded. The frame body has a height not less than 1 mm and not more than 6 mm in a top-underside direction thereof. A groove is formed on at least one of the top surface and the underside surface of the frame body. The groove has a depth not less than 0.2 mm.

The structure described above makes it possible to reduce second area moment of the frame body, because the groove is formed on at least one of the top surface and the underside surface of the frame body. The groove formed as described above reduces flexural rigidity of the support frame and thus reduces restoring force of the support frame for restoring the support frame itself to its former deformed shape, when the support frame is bonded to the flat transparent substrate. The support frame can be thus maintained in a flat state same as that of the transparent substrate.

When the support frame of the present invention is used which has the groove on at least one of the top and the underside surfaces of the frame body, the second area moment of the support frame can be reduced, compared to a case where a groove same in size as that of the present invention is formed on an outer or an inner circumferential surface of the frame body. In other words, the second area moment can be sufficiently reduced in the present invention, even when the groove formed on the frame body is made smaller. Additionally, such a smaller groove requires a smaller amount of machining of the support frame, and the support frame can be thus machined more easily.

In a state where the pellicle film and the transparent substrate are bonded to the support frame of the present invention, a foreign matter such as dust and treatment liquid used in machining can be prevented from entering the groove. This is because the groove is not in communication with external space.

The support frame of the present invention is set to have the groove not less than 0.2 mm in depth which is formed on the frame body not less than 1 mm and not more than 6 mm in height. The height of the frame body and the depth of the groove set as described above makes it possible to sufficiently reduce the second area moment of the support frame.

Additionally, it is preferable to set a ratio of the depth of the groove to the height of the frame body in the top-underside direction, at not less than 10%.

When the pellicle support frame described above has the groove extended in a circumferential direction of the frame body, the second area moment of the support frame can be effectively reduced.

Note that the groove may be formed around the whole circumference of the support frame. Or, a plurality of the grooves may be formed tandemly in the circumferential direction of the frame body.

In the pellicle support frame described above, when a plurality of the grooves are formed in parallel in a width direction of the frame body, the second area moment of the support frame can also be reduced.

In the pellicle support frame described above, when the groove is filled with a resin material, strength of the groove can be increased, compared to the groove of which inside is hollow. Additionally, in this case, a bonding agent can be applied also onto a surface of the resin material. This makes it possible to reliably bond the pellicle film or the transparent substrate to the support frame, without decreasing a bonding area of the support frame, even when the groove is formed thereon.

### ADVANTAGEOUS EFFECTS OF THE INVENTION

The pellicle support frame of the present invention has the frame body having a height not less than 1 mm and not more than 6 mm, at least one of which top surface and undersurface a groove having a depth not less than 0.2 mm is formed. This makes it possible to sufficiently reduce second area moment of the support frame and also reduce flexural rigidity of the support frame.

Thus, when the support frame is bonded to the flat transparent substrate, a restoring force generated in the support frame is reduced. That is, in the present invention, the support frame and the transparent substrate can be maintained in flat states, thus allowing a highly accurate transfer of a circuit pattern of the transparent substrate onto resist on a wafer.

In the present invention, a groove formed on the frame body can be made small in size, and an amount of machining of the support frame can be thus reduced. This makes it possible to machine the support frame more easily.

In the present invention, in a state where the pellicle film and the transparent substrate are bonded to the support frame, a foreign matter such as dust and treatment liquid used in machining can be prevented from entering the groove.

### BRIEF DESCRIPTION OF THE DRAWINGS

FIG. 1 is a perspective diagram illustrating a pellicle and a transparent substrate according to an embodiment of the present invention.
FIG. 2 is a side sectional diagram illustrating the pellicle and the transparent substrate according to the embodiment.
FIG. 3 is a schematic plan diagram illustrating a support frame according to the embodiment.
FIG. 4A is a schematic side diagram illustrating the support frame according to the embodiment. FIG. 4B is a cross sectional diagram thereof when cut along the line A-A. FIG. 4C is a cross sectional diagram thereof when cut along the line B-B.
FIGS. 5A and 5B are each a diagram illustrating a support frame according to another embodiment of the present invention. FIG. 5A is a schematic plan diagram illustrating the support frame on which a plurality of grooves are formed tandemly in a circumferential direction of a frame body. FIG. 5B is a side diagram of FIG. 5A.

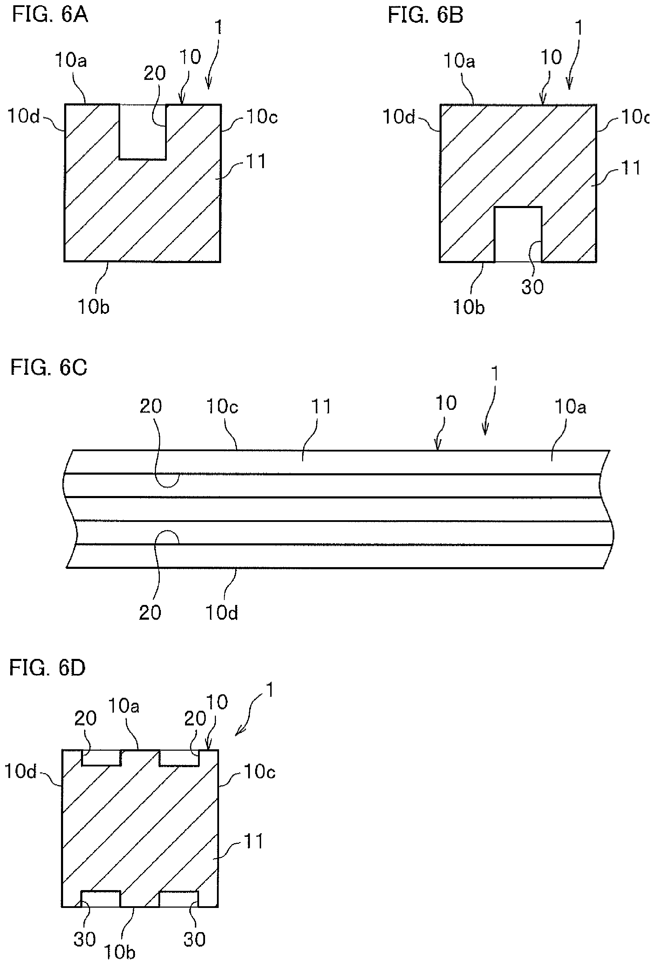

FIG. 6A and 6B are each a diagram illustrating a support frame according to a still another embodiment of the present invention. FIG. 6A is an axial cross sectional diagram illustrating the support frame on which a groove is formed only on an upper surface of the frame body. FIG. 6B is an axial cross sectional diagram illustrating a support frame on which a groove is formed only on an underside surface of the frame body. FIG. 6C and 6D are each a diagram illustrating a support frame according to a yet another embodiment of the present invention. FIG. 6C is a plan diagram illustrating the support frame on which a plurality of grooves are formed in parallel in a width direction of the frame body. FIG. 6D is an axial cross sectional diagram of FIG. 6C.

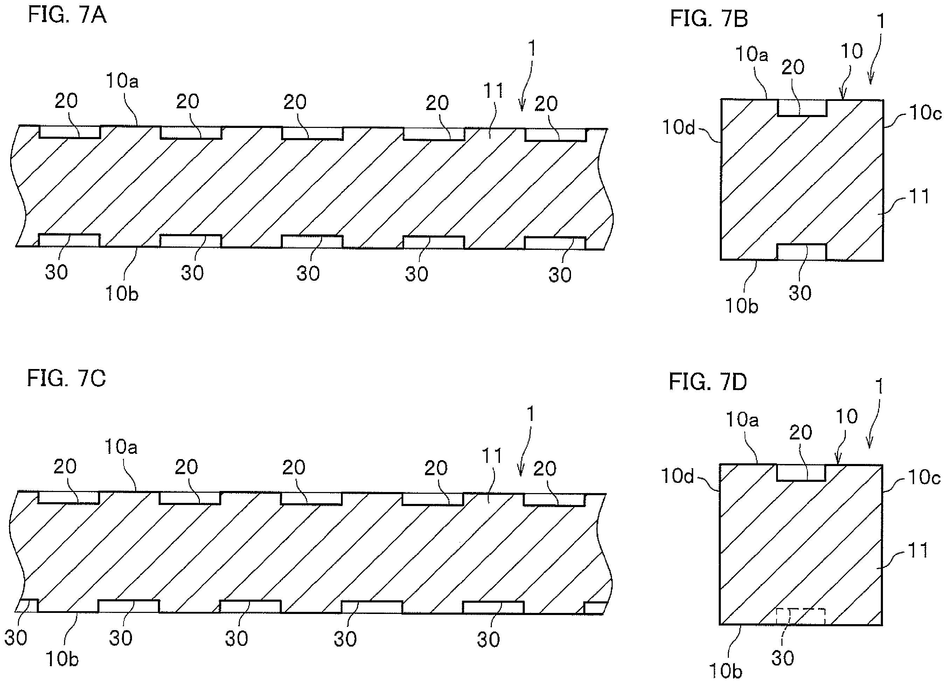

FIGS. 7A and 7B are each a diagram illustrating a support frame according to a further embodiment of the present invention. FIG. 7A is a side sectional diagram illustrating the support frame on which an upper groove and a lower groove are formed symmetrically with respect to the top surface and the underside surface. FIG. 7B is an axial cross sectional diagram of FIG. 7A. FIG. 7C and 7D are each a diagram illustrating a support frame according to a still further embodiment of the present invention. FIG. 7C is a side sectional diagram illustrating the support frame on which an upper groove and a lower groove are formed asymmetrically with respect to the top surface and the underside surface. FIG. 7D is an axial cross sectional diagram of FIG. 7C.
FIG. 8 is a side sectional diagram illustrating a support frame on which a groove is filled with a resin material according to a still further embodiment of the present invention.

### EMBODIMENTS FOR CARRYING OUT THE INVENTION

Embodiments of the present invention are described in detail with reference to related drawings where appropriate.

Each of the figures according to the embodiments illustrates some parts of a support frame schematically where appropriate, so as to make simple explanation of a structure of the support frame.

In the description below, a front and a back, a right and a left, and an upper side and an underside are set so as to simply explain the support frame, which are not intended to limit the structure and a state how the support frame is used.

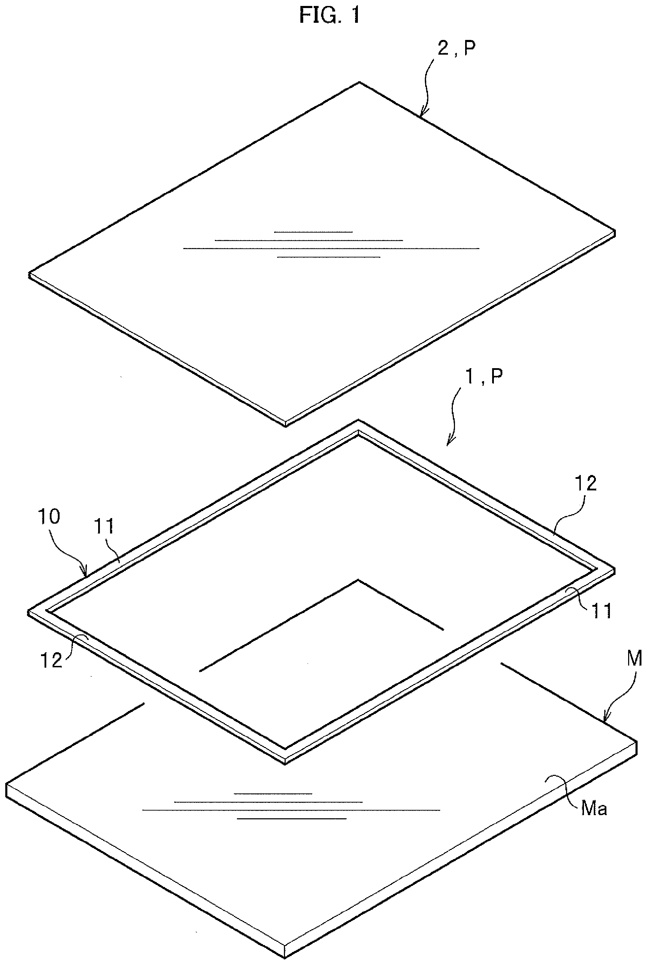

A support frame 1 according to an embodiment is, as illustrated in FIG. 1, used for a pellicle P in a process of manufacturing an integrated circuit. The pellicle P is a dust-proof cover for preventing dust or the like from adhering to a surface Ma of a transparent substrate M (a photomask).

The pellicle P includes: the support frame 1 that surrounds an entire circuit pattern (not shown) drawn on the transparent substrate M; and a pellicle film 2 which covers the surface of the support frame 1.

The support frame 1 includes a frame body 10 which is rectangular as viewed from above. The frame body 10 is manufactured from aluminum alloy material.

The frame body 10 includes: a pair of long frames 11, 11 on a front and a back sides; and a pair of short frames 12, 12 on a right and a left sides. The long frames 11, 11 and the short frames 12, 12 each have a rectangular-shaped cross section.

The long frames 11, 11 constitute long sides of the frame body 10. The short frames 12, 12 constitute short sides of the frame body 10.

The pellicle film 2 is, as illustrated in FIG. 1, a thin translucent film and is manufactured from, for example: cellulosic polymer such as nitrocellulose, cellulose acetate, and cellulose propionate; amorphous fluoric polymer; and the like, which are excellent in ultraviolet transmitting properties.

The pellicle film 2 is rectangular as viewed from above and has a shape same as an outer shape of the support frame 1.

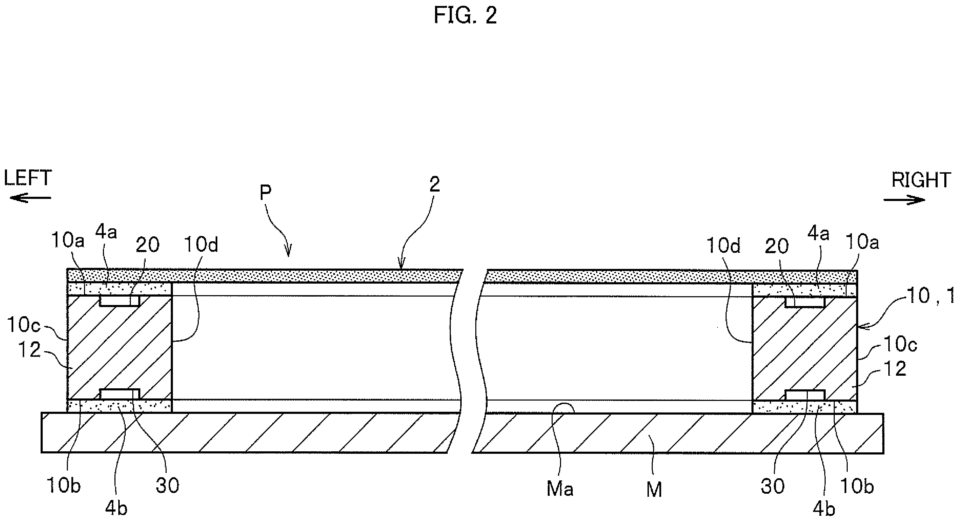

As illustrated in FIG. 2, when the pellicle film 2 is put on a top surface 10a of the frame body 10, the pellicle film 2 covers the whole top surface 10a of the frame body 10.

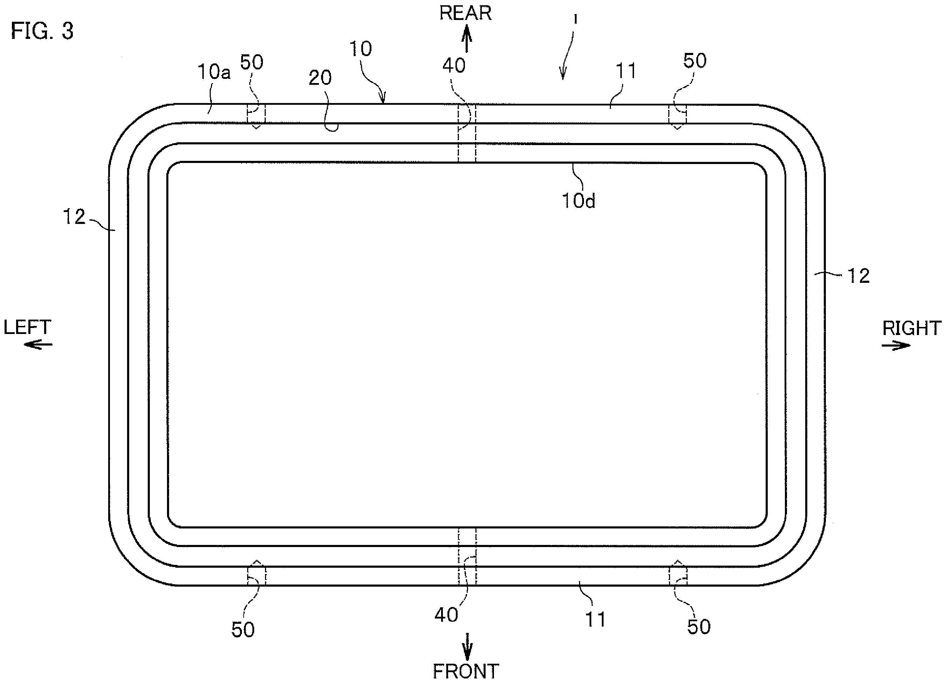

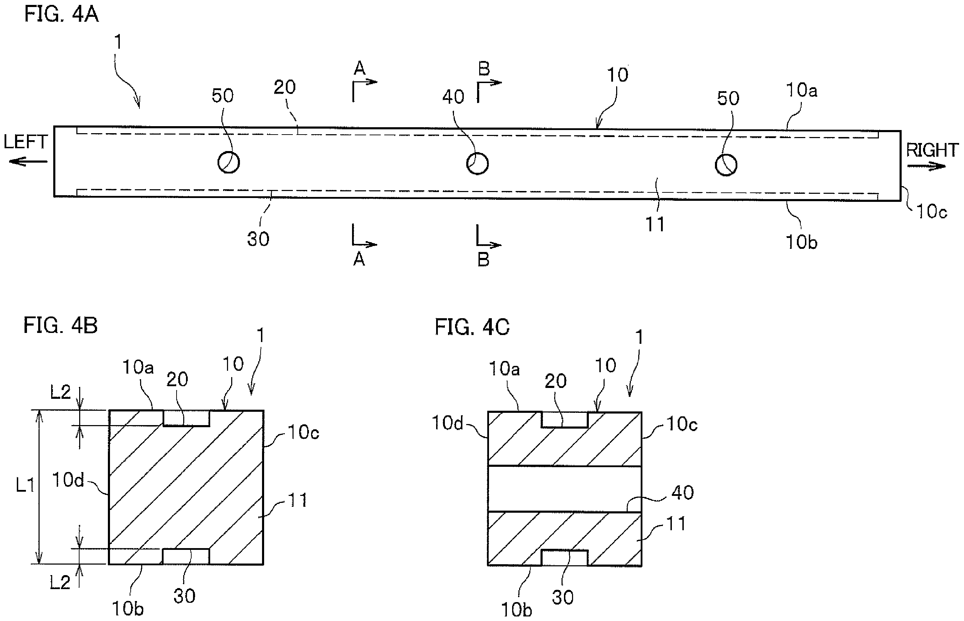

The frame body 10 also includes, as illustrated in FIG. 3: an upper groove 20 formed on the top surface 10a; a lower groove 30 (see FIG. 4A) formed on an underside surface 10b; two through holes 40; and four jig holes 50.

The upper groove 20 on a top side extends in a circumferential direction of the frame body 10 and is formed around the whole circumference of the top surface 10a of the frame body 10. The upper groove 20 has a rectangular-shaped axial cross section (see FIG. 4B).

The upper groove 20 is formed at a center in the front-back direction of the top surface 10a of the long frame 11 (that is, the center in a width direction of the long frame 11), and in a central part in the right-left direction of the top surface 10a (that is, a central part in a width direction of the short frame 12).

The lower groove 30 on an underside extends, as illustrated in FIG. 4A, in the circumferential direction of the frame body 10, similarly to the upper groove 20 on the top side. The underside surface 10b of the frame body 10 is also formed around the whole circumference. The lower groove 30 on the underside also has a rectangular-shaped axial cross section (see FIG. 4B).

The upper groove 20 on the top side and the lower groove 30 on the underside are formed symmetrically with respect to the top surface 10a and the underside surface 10b of the frame body 10, respectively.

The support frame 1 according to this embodiment has, as illustrated in FIG. 4B, the frame body 10 having a height L1 not less than 1 mm and not more than 6 mm. Each of the upper and lower grooves 20, 30 has a depth L2 not less than 0.2 mm. A ratio of a sum (L2+L2) of the depths L2, L2 of the upper and lower grooves 20, 30 to the height L1 of the frame body 10 is set to not less than 10%.

The through hole 40 is a cylindrical hole and penetrates from an outer circumferential surface 10c to an inner circumferential surface 10d of the frame body 10. The through hole 40 is disposed at a center in a height direction of the frame body 10. In this embodiment, as illustrated in FIG. 3, the through hole 40 is formed at the center in the right-left direction of each of the long frames 11, 11. How the through hole 40 is disposed is not, however, limited to this. For example, the through hole 40 may be formed on each of the right and left short frames 12, 12. The number of the through hole 40 is also not limited to that described in this embodiment.

The jig hole 50 is a cylindrical hole having a bottom and is formed on the outer circumferential surface 10c of the long frame 11 (see FIG. 4A). A jig (a pin) of a support device not shown for supporting the support frame 1 is inserted into the jig hole 50 at a time when the support frame 1 is manufactured or the pellicle P (see FIG. 1) is used.

The support frame 1 according to this embodiment has the jig holes 50 on both sides of each of the long frames 11, 11. This can reduce deflection of the long frame 11 when the jig supports the support frame 1, compared to when the jig hole 50 is formed at the center in the right-left direction of the long frame 11.

Note that in this embodiment, as illustrated in FIG. 4A, the jig hole 50 is disposed at a center in a height direction of the frame body 10. The height of the jig hole 50 is not, however, limited to this, and is set depending on the jig to be used.

In bonding the pellicle film 2 and the transparent substrate M to the support frame 1, as illustrated in FIG. 2, a bonding agent made of acrylic resin, epoxy resin, or the like is first applied to the top surface 10a of the frame body 10 to form a bonding layer 4a on the top surface 10a of the frame body 10. At this time, the bonding layer 4a is kept from running into the upper groove 20.

After that, the pellicle film 2 is put onto an upper surface of the bonding layer 4a, to thereby bond the pellicle film 2 to the top surface 10a of the frame body 10 via the bonding layer 4a. This allows the upper groove 20 to be sealed with the pellicle film 2.

An adhesive layer 4b made of polybutene resin, polyvinyl acetate resin, acrylic resin, or the like is formed on the underside surface 10b of the frame body 10. At this time, the adhesive layer 4b is kept from running into the lower groove 30.

The adhesive layer 4b on an underside is laid on an upper surface Ma of the transparent substrate M, and the support frame 1 is pressed against the transparent substrate M. The support frame 1 is thus bonded to the upper surface Ma of the transparent substrate M via the adhesive layer 4b. This allows the lower groove 30 to be sealed with the transparent substrate M.

Bonding of the pellicle P to the transparent substrate M as described above means that the support frame 1 is interposed between the pellicle film 2 and the transparent substrate M and that the pellicle film 2 is thus disposed apart from the upper surface Ma of the transparent substrate M.

The pellicle P has the two through holes 40, 40 (see FIG. 3) formed on the frame body 10 of the support frame 1. This makes it possible to prevent a difference in pressure from being generated between an inner space and an external space of the frame body 10, even when the top and underside surfaces 10a, 10b of the frame body 10 are sealed with the pellicle film 2 and the transparent substrate M, respectively. This is because the inner space of the frame body 10 is in communication with the external space via the through holes 40, 40.

The support frame 1 described above has, as illustrated in FIG. 4B, the upper and lower grooves 20, 30 each having the depth L2 not less than 0.2 mm are formed on the top surface 10a and the underside surface 10b of the frame body 10 each having the height L1 not less than 1 mm and not more than 6 mm. A ratio of a sum (L2+L2) of the depths L2, L2 of the upper and lower grooves 20, 30 to the height L1 of the frame body 10 is set to be not less than 10%.

The depths L2, L2 of the upper and lower grooves 20, 30 with respect to the height L1 of the frame body 10 set as described above makes it possible to sufficiently reduce second area moment around the gravity center of the support frame 1.

Additionally, because both of the upper and lower grooves 20, 30 extend in the circumferential direction of the frame body 10, second area moment generated in the support frame 1 can be effectively reduced.

As a result, flexural rigidity of the support frame 1 illustrated in FIG. 2 is reduced, and a restoring force of the support frame 1 becomes small which is a force to restore the support frame 1 to its former deformed shape after the support frame 1 is bonded to the flat transparent substrate M. That is, the support frame 1 and the transparent substrate M can be maintained in flat states, thus allowing a highly accurate transfer of a circuit pattern of the transparent substrate M onto resist on a wafer.

The second area moment of the support frame 1 can be further sufficiently reduced, when the upper and lower grooves 20, 30 each having the depth not less than 0.2 mm are formed on the top surface 10a and the underside surface 10b of the frame body 10, each having a height not less than 2 mm and not more than 3 mm, respectively.

Note that, if the upper and lower grooves 20, 30 are formed on the frame body 10 having a height less than 1 mm, strength of the frame body 10 becomes too small. If the upper and lower grooves 20, 30 are formed on the frame body 10 having a height more than 6 mm, flexural rigidity of the frame body 10 cannot be sufficiently reduced, because the flexural rigidity of the frame body 10 is large.

As in the support frame 1 according to this embodiment, when the upper and lower grooves 20, 30 are formed on the top surface 10a and the underside surface 10b of the frame body 10, respectively, the second area moment of the support frame 1 can be reduced, compared to a case where a groove of the same size as described above is formed on the outer circumferential surface 10c or an inner circumferential surface 10d of the frame body 10. That is, the second area moment of the support frame 1 according to this embodiment can be sufficiently reduced, even when the upper and lower grooves 20, 30 formed on the frame body 10 are made small in size. Additionally, the small upper and lower grooves 20, 30 requires a small amount of machining of the support frame 1, and the support frame 1 can be thus machined more easily.

In a state where the pellicle film 2 and the transparent substrate M are bonded to the support frame 1, a foreign matter such as dust and treatment liquid used in machining can be prevented from entering the upper and lower grooves 20, 30. This is because the upper and lower grooves 20, 30 are not in communication with the external space.

The embodiment of the present invention has been described above. The present invention is not, however, limited to the aforementioned embodiment, and various changes are possible within a scope not departing from the gist of the present invention.

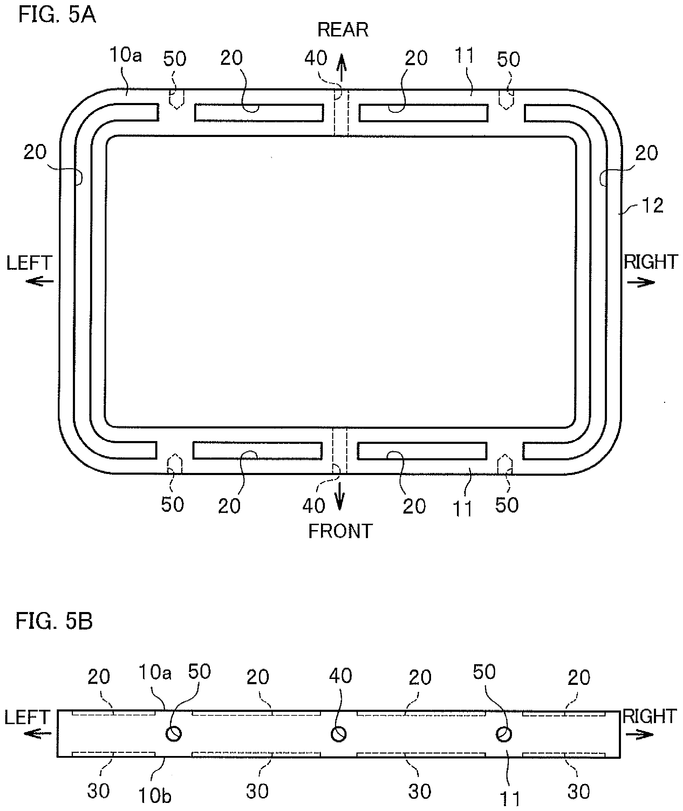

In the embodiment, as illustrated in FIG. 3, the upper and lower grooves 20, 30 (see FIG. 4A) are formed each on the whole circumference of the frame body 10. However, a plurality of the upper and lower grooves 20, 30 may be each formed tandemly in the circumferential direction of the frame body 10, as illustrated in FIG. 5A and FIG. 5B.

In the latter structure, the through holes 40 or the jig holes 50 are appropriately arranged between the neighboring upper grooves 20, 20 and between the neighboring lower grooves 30, 30. This can ensure strength of the frame body 10, because the upper and lower grooves 20, 30 and the through hole 40 or the jig hole 50 do not overlap with each other with respect to an upper-lower direction of the frame body 10.

In the embodiment, as illustrated in FIG. 4B, the upper and lower grooves 20, 30 are formed on the top surface 10a and the underside surface 10b of the frame body 10, respectively. However, as illustrated in FIG. 6A, only the upper groove 20 may be formed on the top surface 10a of the frame body 10. Or, as illustrated in FIG. 6B, only the lower groove 30 may be formed on the underside surface 10b of the frame body 10.

Note that even when only the upper groove 20 is formed on the top surface 10a of the frame body 10 or even when only the lower groove 30 is formed on the underside surface 10b, as illustrated in FIGS. 6A and 6B, respectively, the frame body 10 is formed to be not less than 1 mm and not more than 6 mm in height, and the upper and lower grooves 20, 30 are each formed to be not less than 0.2 mm in depth. This makes it possible to sufficiently reduce the second area moment of the support frame 1. Additionally, it is preferable to set a ratio of the depth of each of the upper groove 20 on the top side and the lower groove 30 on the underside, to the height of the frame body 10, at not less than 10%.

As illustrated in FIGS. 6C and 6D, two upper grooves 20, 20 may be arranged on the top surface 10a of the frame body 10 in parallel in the width direction, and two underside grooves 30, 30 may be arranged on the underside surface 10b of the frame body 10 in parallel in the width direction. Alternatively, three or more upper and lower grooves 20, 30 may be arranged in parallel in the width direction of the frame body 10. Or, a plurality of grooves may be arranged either on the top surface 10a or on the underside surface 10b of the frame body 10 in parallel in the width direction.

As illustrated in FIGS. 7A and 7B, a plurality of each of the upper and lower grooves 20, 30 may be arranged at intervals tandemly in the circumferential direction of the frame body 10, such that each of the upper grooves 20 on the top side and each of the underside grooves 30 on the underside are positioned symmetrically in the top-underside direction, respectively.

As illustrated in FIGS. 7C and 7D, a plurality of the upper and lower grooves 20, 30 may be arranged at intervals tandemly in the circumferential direction of the frame body 10. In this structure, the upper and lower grooves 20, 30 on the upper and lower surfaces, respectively, may be shifted with each other in the circumferential direction of the frame body 10, such that the upper and lower grooves 20, 30 on the top side and on the underside, respectively, do not overlap with each other in the top-underside direction. When the upper groove 20 on the top side and the lower groove 30 on the underside are formed asymmetrically in the top-underside direction as described above, strength of the frame body 10 can also be assured.

In the embodiment, as illustrated in FIG. 3, the two through holes 40, 40 are provided. The number or layout of the through holes 40, 40 is not, however, limited to this, and is appropriately set depending on a size of the frame body 10.

In the embodiment, as illustrated in FIG. 4A, each of the through holes 40 and the jig holes 50 is formed at a center in the height direction of the frame body 10, and may also be formed off the center in the height direction of the frame body 10.

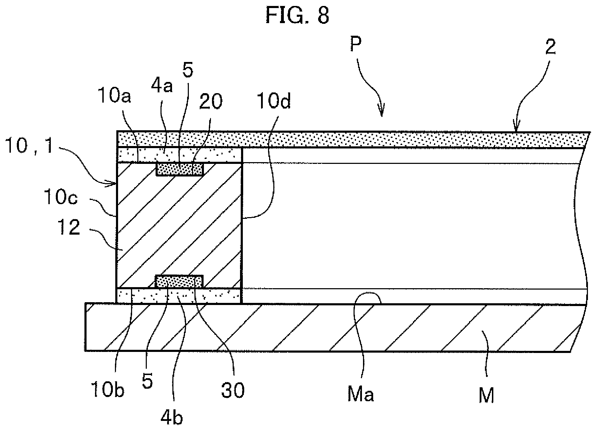

As illustrated in FIG. 8, the upper and lower grooves 20, 30 on the top side and underside, respectively, may be filled with a resin material 5. In this structure, strength of the frame body 10 can be increased, compared to the upper and lower grooves 20, 30, of which inside are hollow. Additionally, the structure allows a bonding agent to be applied also to a surface of the resin material 5. This makes it possible to steadily bond the pellicle film 2 or the transparent substrate M to the support frame 1, without decreasing a bonding area of the support frame 1 with the frame body 10 having the upper and lower grooves 20, 30 formed thereon. Note that only one of the upper and lower grooves 20, 30 may be filled with the resin material 5.

### DESCRIPTION OF REFERENCE NUMERALS

- 1: support frame
- 2: pellicle film
- 4a: bonding layer
- 4b: adhesive layer
- 10: frame body
- 11: long frame
- 12: short frame
- 20: upper groove
- 30: lower groove
- 40: through hole
- 50: jig hole
- M: transparent substrate
- P: pellicle

## Claims

1. A pellicle support frame comprising a frame body made of aluminum alloy,
wherein the frame body has a top surface onto which a pellicle film is bonded and has an underside surface onto which a transparent substrate is bonded,
wherein the frame body has a height not less than 1 mm and not more than 6 mm in a top-underside direction thereof,
wherein a groove is formed on at least one of the top surface and the underside surface of the frame body, and
wherein the groove has a depth not less than 0.2 mm.

2. The pellicle support frame according to claim 1,
wherein a ratio of the depth of the groove to the height of the frame body in the top-underside direction is not less than 10%.

3. The pellicle support frame according to claim 1 or claim 2,
wherein the groove extends in a circumferential direction of the frame body.

4. The pellicle support frame according to claim 1 or claim 2,
wherein a plurality of the grooves are formed tandemly in the circumferential direction of the frame body.

5. The pellicle support frame according to claim 1 or claim 2,
wherein a plurality of the grooves are formed in parallel in a width direction of the frame body.

6. The pellicle support frame according to claim 1 or claim 2,
wherein the groove is filled with a resin material.
